(19) Europäisches Patentamt / European Patent Office / Office européen des brevets

(11) **EP 4 414 714 B1**

(12) **FASCICULE DE BREVET EUROPEEN**

(45) Date de publication et mention
de la délivrance du brevet:
**01.07.2026 Bulletin 2026/27**

(21) Numéro de dépôt: **23305189.5**

(22) Date de dépôt: **13.02.2023**

(51) Classification Internationale des Brevets (IPC):
*G01R 15/04* (2006.01)    *G01R 1/20* (2006.01)
*G01R 15/00* (2006.01)    *G01R 15/08* (2006.01)
*G01R 31/00* (2006.01)

(52) Classification Coopérative des Brevets (CPC):
**G01R 1/203; G01R 15/002; G01R 15/04;
G01R 15/08; G01R 31/006; G01R 31/008**

(54) **SYSTÈME DE DÉTECTION BASÉ SUR UN CIRCUIT ÉLECTRIQUE DE GÉNÉRATION D'UN SIGNAL ANALOGIQUE POUR UN VÉHICULE**

AUF EINEM ELEKTRISCHEN SCHALTKREIS BASIERENDES DETEKTIONSSYSTEM ZUR ERZEUGUNG EINES ANALOGEN SIGNALS FÜR EIN FAHRZEUG

DETECTION SYSTEM BASED ON AN ELECTRIC CIRCUIT FOR GENERATING AN ANALOGUE SIGNAL FOR A VEHICLE

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date de publication de la demande:
**14.08.2024 Bulletin 2024/33**

(73) Titulaire: **SpeedInnov
75008 Paris (FR)**

(72) Inventeurs:
• **CAMPS, Jean-Bernard
17000 LA ROCHELLE (FR)**
• **RABIER, François
17140 LAGORD (FR)**

(74) Mandataire: **Plasseraud IP
104 Rue de Richelieu
CS92104
75080 Paris Cedex 02 (FR)**

(56) Documents cités:
**CN-U- 216 772 219        US-A- 4 994 733
US-A1- 2012 182 065    US-A1- 2018 143 250**

## Description

La présente invention concerne un circuit électrique de génération d'un signal analogique pour un véhicule.

L'invention concerne en outre un système de détection d'un signal analogique associé.

De manière connue en soi, il convient de surveiller l'état d'une pluralité d'équipements électriques ou électroniques au sein d'un véhicule, par exemple d'un véhicule ferroviaire. Pour ce faire, des véhicules sont équipés de modules d'entrée/sortie permettant de recevoir des signaux de ces équipements indiquant les états respectifs, et transmettre ces états par exemple à un contrôleur du véhicule. Les signaux sont par exemple des signaux logiques, ou binaires, c'est-à-dire des signaux présentant deux états possibles, par exemple indiquant un fonctionnement nominal ou une défaillance.

US20180143250A1 décrit un système de détection d'état d'interrupteurs, CN216772219U décrit un système pour détecter l'évolution de grandeurs physiques, et US20120182065A et US4994733A1 décrivent des systèmes de détection de tension.

Lors d'une augmentation du nombre d'équipements au sein du véhicule, il convient par conséquent de surveiller un plus grand nombre d'états.

Toutefois, lors d'un ajout d'équipements à surveiller dans le véhicule, il peut s'avérer difficile de surveiller l'état de ces équipements additionnels par intermédiaire des modules d'entrée/sortie existants. Les modules d'entrée/sortie comprennent en effet un nombre d'entrées prédéterminé.

Aussi, l'espace au sein des véhicules est limité, ce qui vient limiter la possibilité d'un ajout de modules d'entrée/sortie additionnels.

De plus, l'ajout de modules d'entrée/sortie additionnels présente des inconvénients, puisque cet ajout agrandit et alourdit le système configuré pour transmettre les états des équipements.

Un but de l'invention est ainsi de pallier les inconvénients précités.

En particulier, un but de la présente invention est d'obtenir un circuit électrique, et notamment un système de détection comprenant un tel circuit électrique, permettant la surveillance d'un grand nombre d'équipements d'un véhicule, tout en étant peu encombrant et léger.

A cet effet, l'invention a pour objet un système de détection, selon la revendication 1.

Le système de détection selon l'invention permet en effet de surveiller un grand nombre d'équipements du véhicule, sans l'ajout de modules d'entrée/sortie additionnels. En effet, le circuit électrique permet de générer un signal analogique qui comprend une tension spécifique, c'est-à-dire unique, indicative de l'ensemble des états des équipements via leur contact d'état associé.

Grâce au circuit électrique, le signal analogique est obtenu notamment pour une transmission à un module d'entrée/sortie, au lieu par exemple de signaux logiques indiquant l'état binaire de chaque équipement séparément. Le signal analogique obtenu par le circuit électrique de l'invention comprend alors l'information relative à l'état d'un grand nombre d'équipements du véhicule. Dans la mesure où chaque résistance de détection présente une valeur différente par rapport à chaque valeur des autres résistances de détection, le signal analogique présente une tension unique, qui dépend de l'état de chaque contact d'état des équipements surveillés.

Selon d'autres aspects avantageux, le système de détection comprend en outre les caractéristiques des revendications 2 à 6.

Ces caractéristiques et avantages de l'invention apparaitront à la lecture de la description qui va suivre, donnée uniquement à titre d'exemple non limitatif, et faite en référence au dessin annexé sur lequel :

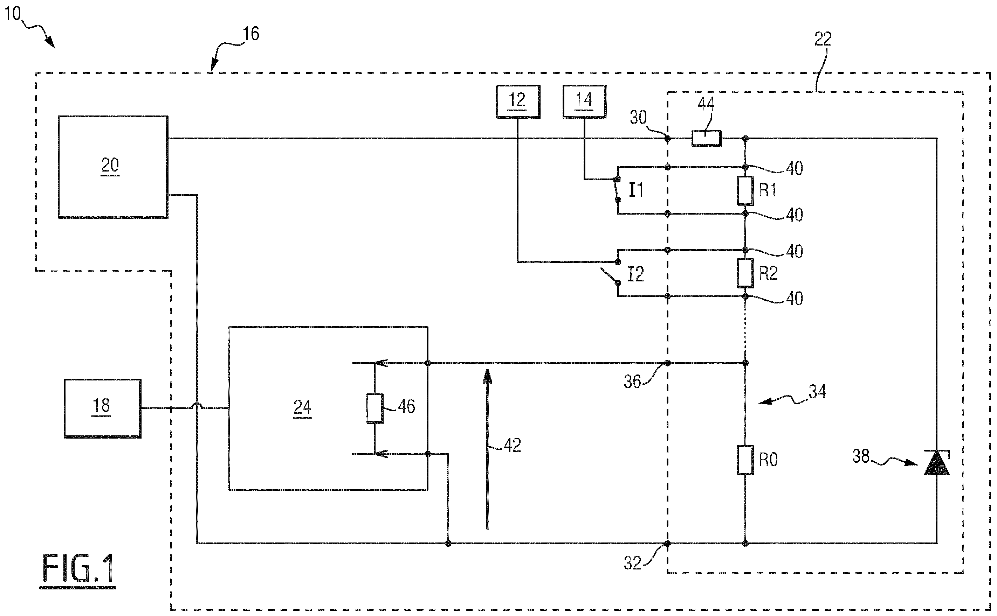

- la figure 1 est une représentation schématique d'une partie d'un véhicule comprenant un système de détection d'un signal analogique.

En référence à la figure 1, un véhicule 10 comprend une pluralité d'équipements 12, 14, un système de détection 16, et un contrôleur 18.

Le véhicule 10 est de préférence un véhicule ferroviaire. En variante, le véhicule 10 est un véhicule terrestre ou un navire.

De préférence, le véhicule 10 comprend un nombre d'équipements n, où n est un nombre entier supérieur ou égal à 2, de préférence n étant au moins 20, de préférence encore n étant au moins 100.

Chaque équipement 12, 14 est en particulier un équipement disposant d'une interface électrique.

Chaque équipement 12, 14 présente un état de fonctionnement nominal, et au moins un état de défaillance.

Chaque équipement 12, 14 est par exemple un disjoncteur, un interrupteur ou commutateur de fin de course, un relais, un contacteur, manostat ou une électrovanne.

Le système de détection 16 comprend une pluralité de contacts d'état I1 à Ix, désignés sur la figure 1 par exemple par I1 et I2, une source de tension 20, au moins un circuit électrique 22 et un module d'entrée/sortie 24.

Selon un exemple, le système de détection 16 comprend plusieurs circuits électriques 22. Dans ce cas, par exemple, chaque circuit électrique 22 est relié à une entrée analogique qui lui est propre ou qui lui est dédiée ou qui est associée à ce circuit électrique 22, d'un même module ou de modules d'entrée/sortie 24 différents

De préférence, le système de détection comprend x contacts d'état, où x est un nombre entier supérieur ou égal à 2. De préférence, le nombre x est égal au nombre n d'équipements du véhicule 10.

Chaque contact d'état I1 à Ix est associé à un équipement 12, 14 respectif. En particulier, chaque contact d'état I1 à Ix est relié à un équipement 12, 14 respectif. Par exemple, le contact d'état I1 est relié à l'équipement 14, et le contact d'état I2 est relié à l'équipement 12.

Chaque contact d'état I1 à Ix présente un état choisi entre l'état fermé et l'état ouvert. Cet état dépend en particulier de l'état de fonctionnement de l'équipement 12, 14 du véhicule 10, qui est associé au contact respectif I1 à Ix.

Chaque contact d'état I1 à Ix est en particulier un contact électrique configuré pour permettre le passage ou interrompre le passage d'un courant entre ses bornes. Selon un exemple d'implémentation, chaque contact d'état I1 à Ix prend la forme d'un interrupteur ayant soit l'état fermé, soit l'état ouvert.

De préférence, chaque contact d'état I1 à Ix est dans l'état fermé lorsque l'équipement 12, 14 associé à ce contact d'état est dans l'état de fonctionnement nominal. Par exemple, chaque contact d'état I1 à Ix est dans l'état ouvert lorsque l'équipement 12, 14 associé à ce contact d'état est dans un état défaillant. Par exemple, en référence à la figure 1, le contact d'état I1 est dans l'état fermé, indiquant ainsi que l'équipement 14 est dans l'état de fonctionnement nominal. Le contact I2 est, dans cet exemple, dans l'état ouvert, indiquant ainsi que l'équipement 12 est dans l'état de défaillance.

Par exemple, l'état de chaque contact d'état I1 à Ix forme une entrée logique pour le circuit électrique 22.

Par « entrée logique », il est entendu une entrée présentant deux valeurs possibles, également appelée entrée binaire, par exemple soit la valeur « 0 », soit la valeur « 1 ».

La source de tension 20 est configurée pour fournir une tension électrique prédéterminée. Par exemple, la source de tension 20 est une source de tension continue.

Par exemple, la source de tension 20 est configurée pour fournir une tension sensiblement égale à 24 V, notamment en tension continue.

Le circuit électrique 22 est décrit plus en détail dans ce qui suit.

Lorsque le système de détection 16 comprend plusieurs circuits électriques 22, chaque circuit électrique 22 est de préférence identique.

De préférence, notamment pour un gain de place, le circuit électrique 22 est réalisé sous forme de composant monté en surface, dont le sigle est CMS, également appelé en anglais « Surface Mounted Device ».

En variante, le circuit électrique 22 est réalisé avec des composants classiquement utilisés pour des circuits électriques.

En variante, notamment pour un gain de place, le circuit électrique 22 est réalisé sous forme d'un plug configuré pour être branché à une entrée du module d'entrée/sortie 24, ainsi qu'à des sorties des contacts d'état I1 à Ix.

En variante encore, le circuit électrique 22 est réalisé sous forme d'une carte électronique ou d'un bornier équipé.

Le circuit électrique 22 comprend deux bornes d'entrée 30, 32, une branche principale 34 reliant les bornes d'entrée 30, 32, au moins une borne de sortie 36 et une diode 38, notamment une diode Zener 38 pour adapter la tension au module d'entrée/sortie 24.

Les bornes d'entrée 30, 32 sont configurées pour recevoir la tension électrique prédéterminée de la source de tension 20. En particulier, les bornes d'entrée 30, 32 sont électriquement reliées à la source de tension 20.

La branche principale 34, qui relie les bornes d'entrée 30, 32, comprend une pluralité de résistances de détection R1 à Rx de valeurs uniques.

Par « valeur unique », il est entendu que la valeur de chaque résistance est différente par rapport à chaque valeur des autres résistances de détection R1 à Rx.

Dans l'exemple de la figure 1, la branche principale 34 comprend la résistance de détection R1 et la résistance de détection R2. Les résistances de détection R1 à Rx sont connectées en série entre lesdites bornes d'entrée 30, 32.

La branche principale 34 comprend par exemple en outre au moins une résistance de service R0. La résistance de service R0 est connectée en série entre l'une des résistances de détection R1 à Rx et l'une des bornes d'entrée 30, 32. Par exemple, la résistance de service R0 est connectée entre la résistance de détection R2 et la borne de sortie 32.

La branche principale 34 comprend en outre, pour chaque résistance de détection R1 à Rx, deux bornes de court-circuitage 40 configurées pour court-circuiter la résistance de détection respective R1 à Rx lorsque le contact d'état I1 à Ix reliant ces bornes de court-circuitage est en état fermé. De préférence, les bornes de court-circuitage 40 sont, pour une résistance R1 à Rx spécifique, positionnées de part et d'autre de cette résistance, ou à des extrémités opposées de cette résistance.

Par exemple, lorsque le contact d'état I1 est dans l'état fermé, la résistance R1 est court-circuitée par ces bornes de court-circuitage 40 qui relient des extrémités de cette résistance entre elles par l'intermédiaire du contact d'état I1. Selon l'exemple de la figure 1, lorsque le contact d'état I2 est dans l'état ouvert, les bornes de court-circuitage 40 positionnées de part et d'autre de la résistance R2 ne court-circuitent pas cette résistance, puisque le contact d'état I2 est ouvert.

Chaque résistance de détection R1 à Rx est associée au contact d'état correspondant I1 à Ix, et en particulier reliée à ce contact d'état par les bornes de court-circuitage 40 respectives.

Chaque résistance de détection R1 à Rx présente une valeur de résistance différente par rapport à chaque valeur de résistance des autres résistances de détection I1 à Ix. En particulier, chaque résistance de détection R1 à Rx présente une valeur de résistance unique, ou valeur unique. De préférence, chaque résistance de détection R1 à Rx présente sa valeur unique de résistance avec une tolérance inférieure ou égale à 1% de la valeur de résistance. Cela permet d'obtenir un très grand nombre de tensions différentes en fonction des états des contacts d'état I1 à Ix, et permet ainsi, à partir d'une seule valeur de tension, d'obtenir une information sur l'état de chaque contact d'état I1 à Ix.

La borne de sortie 36 est connectée à la branche principale 34 de sorte à obtenir un signal analogique comprenant une tension unique dépendant de l'état de chaque contact d'état I1 à Ix.

Par « tension unique », il est entendu une valeur de tension uniquement obtenue pour une combinaison spécifique des états des contacts d'état I1 à Ix. Par exemple, lors de la fermeture et/ou ouverture de l'un ou plusieurs des contacts d'état I1 à Ix, du fait de la valeur différente de chaque résistance R1 à Rx, la tension unique varie.

Par exemple, la borne de sortie 36 est connectée à un point milieu entre l'une des résistances de détection R1 à Rx et la résistance de service R0.

De préférence, la tension unique est la tension entre la borne de sortie 36 et l'une des bornes d'entrée 30, 32. Par exemple, en référence à la figure 1, la tension unique est la tension entre la borne de sortie 36 et la borne d'entrée 32. Dans l'exemple de la figure 1, la tension unique est désignée par une flèche 42.

De préférence, le circuit électrique 22 forme un diviseur de tension, fournissant en sortie la tension unique mesurée sur la résistance de service R0.

La diode 38 du circuit électrique 22 relie les bornes d'entrée 32 et 30, en particulier par une connexion parallèle à la branche principale 34. En particulier, la diode 38 est une diode Zener.

La diode 38 est en particulier configurée pour décréter une valeur de tension spécifique à partir de la tension électrique prédéterminée reçue de la source de tension 20. En particulier, la diode 38 permet d'obtenir une valeur de tension présentant une tolérance faible. Par exemple, la diode 38 est configurée pour décréter une tension égale à 20 V entre les bornes d'entrée 30, 32.

De préférence, la valeur de la tension unique satisfait l'équation suivante, lorsque le contact d'état Ix de la résistance de détection Rx, dite résistance active, est dans l'état ouvert :

$$V_S = \frac{R_{0,t} \cdot V_E}{R_{0,t} + R_X}$$

où :

$V_S$ est la valeur de la tension unique comprise dans le signal analogique, en particulier entre la borne de sortie 36 et la borne d'entrée 32 ;
$R_{0,t}$ est la valeur de la résistance de service R0, ajustée de préférence par une tolérance de résistance prédéterminée ;
$V_E$ est la valeur de la tension électrique prédéterminée entre les bornes d'entrée 30, 32, et
$R_X$ est la valeur de la résistance active.

La valeur $R_{0,t}$ est par exemple déterminée en fonction de la valeur de la résistance R0 et en fonction de la valeur d'une résistance interne 46 (décrite ci-dessous) du module d'entrée/sortie 24. En particulier, la combinaison des valeurs de résistance donne une valeur équivalente de résistance.

De préférence, la valeur de la résistance R0 est au moins d'un ordre de grandeur inférieur par rapport à la valeur de la résistance interne 46.

La résistance $R_{0,t}$ impose notamment une plage de tension disponible, et est par exemple modifiable suivant la résistance interne 46.

Le nombre utilisable de résistances de détection R1 à Rx dépend par exemple de la résistance $R_{0,t}$, compte tenu notamment d'une valeur minimale de chaque résistance de détection.

Selon l'exemple, le circuit électrique 22 présente une résistance 44 liée à la diode 38, notamment la diode Zener. Cette résistance 44 est configurée pour limiter le courant passant par la diode 38. Cela permet ainsi par exemple de limiter la tension de l'entrée analogique au module d'entrée/sortie 24.

Le module d'entrée/sortie 24 est configuré pour recevoir en entrée le signal analogique du ou de chaque circuit électrique 22, comprenant la tension unique, qui dépend de l'état de chaque contact d'état I1 à Ix du circuit électrique 22 respectif.

Le module d'entrée/sortie 24 est configuré pour transmettre un signal de détection comprenant le ou chaque signal analogique au contrôleur 18.

De préférence, le module d'entrée/sortie 24 est positionné à distance par rapport au contrôleur 18, par exemple dans un compartiment différent ou une voiture différente du véhicule 10 rapport au contrôleur 18.

De préférence, le module d'entrée/sortie 24 est un produit informatique COTS (de l'anglais « Commercial Off-The-Shelf » pour produit vendu sur étagère).

De préférence, le module d'entrée/sortie 24 comprend par exemple une résistance interne 46 permettant de mesurer la tension unique par un circuit interne, non représenté, du module d'entrée/sortie 24.

Le module d'entrée/sortie 24 est par exemple un module BRIO (de l'anglais « Basic Remote Input/Output » module pour module basique d'entrée/sortie à distance).

Selon un autre exemple, le module d'entrée/sortie 24 est un module RIOM (de l'anglais « Remote Input/Output Module » pour module à distance d'entrée/sortie).

On conçoit que l'invention présente un certain nombre d'avantages.

En effet, le circuit électrique 22 permet de transformer une pluralité d'entrées logiques reçues aux bornes de court-circuitage 40 dans un signal analogique qui comprend l'information des états des contacts d'état I1 à Ix, sous forme de la tension unique.

En particulier, le circuit électrique 22 permet de s'affranchir d'un ajout de module d'entrée/sortie 24 additionnel pour détecter un plus grand nombre d'états d'équipements 12, 14.

## Revendications

1. Système de détection (16) d'un signal analogique comprenant une pluralité de circuits électriques (22) de génération d'un signal analogique pour un véhicule ferroviaire (10), chaque circuit électrique (22) comprenant deux bornes d'entrée (30, 32) configurées pour recevoir une tension électrique prédéterminée définie entre lesdites bornes d'entrée (30, 32), chaque circuit électrique (22) comprenant en outre une branche principale (34) reliant lesdites bornes d'entrée (30, 32),

   dans lequel la branche principale (34) comprend une pluralité de résistances de détection (R1, R2), connectées en série entre lesdites bornes d'entrée (30, 32), chaque résistance de détection (R1, R2) présentant une valeur différente par rapport à chaque valeur des autres résistances de détection (R1, R2), et
   la branche principale comprenant en outre, pour chaque résistance de détection (R1, R2), deux bornes de court-circuitage (40) configurées pour court-circuiter la résistance de détection (R1, R2) respective lorsqu'un état d'un contact d'état (I1, I2) reliant lesdites bornes de court-circuitage (40) est en un état fermé,
   chaque circuit électrique (22) comprenant en outre au moins une borne de sortie (36) connectée à la branche principale (34) de sorte à obtenir le signal analogique comprenant une tension unique dépendant de l'état de chaque contact d'état (I1, I2), le système de détection (16) comprenant en outre, pour chaque résistance de détection (R1, R2), le contact d'état (I1, I2) configuré pour relier les bornes de court-circuitage (40) respectives dans l'état fermé,
   l'état de chaque contact d'état (I1, I2) dépendant d'un état de fonctionnement d'un équipement (12, 14) du véhicule (10) associé audit contact d'état (I1, I2), de préférence, chaque contact d'état (I1, I2) étant dans l'état fermé lorsque l'équipement (12, 14) associé audit contact d'état (I1, I2) est dans un état de fonctionnement nominal,
   le système de détection (16) comprenant en outre un module d'entrée/sortie (24) configuré pour recevoir le signal analogique de chaque circuit électrique (22), et configuré pour transmettre un signal de détection comprenant le signal analogique de chaque circuit électrique (22) à un contrôleur (18) du véhicule (10).

2. Système de détection (16) selon la revendication 1, dans lequel la branche principale (34) comprend en outre une résistance de service (R0) connectée en série entre l'une des résistances de détection (R1, R2) et l'une des bornes d'entrée (30, 32), la borne de sortie (36) étant connectée à un point milieu entre ladite résistance de détection (R1, R2) et la résistance de service (R0).

3. Système de détection (16) selon la revendication 2, dans lequel la tension unique est la tension entre la borne de sortie (36) et l'une des bornes d'entrée (30, 32).

4. Système de détection (16) selon l'une quelconque des revendications précédentes, comprenant en outre au moins une diode (38) reliant les bornes d'entrée (30, 32), de préférence reliant les bornes d'entrée (30, 32) par une connexion parallèle à la branche principale (34), la diode étant de préférence une diode Zener.

5. Système de détection (16) selon l'une quelconque des revendications précédentes, réalisé sous forme de composant monté en surface.

6. Système de détection (16) selon l'une quelconque des revendications précédentes, dans lequel la valeur de la tension unique satisfait l'équation suivante, lorsque le contact d'état de l'une des résistances de détection (R1, R2), dite résistance active, est dans un état ouvert :

$$V_S = \frac{R_{0,t} \cdot V_E}{R_{0,t} + R_X}$$

où :

   $V_S$ est la valeur de la tension unique comprise dans le signal analogique ;
   $R_{0,t}$ est la valeur de la résistance de service, ajustée de préférence par une tolérance de résistance prédéterminée ;
   $V_E$ est la valeur de la tension électrique prédéterminée entre les bornes d'entrée (30, 32), et
   $R_X$ est la valeur de la résistance active.

**Patentansprüche**

1. Detektionssystem (16) für ein analoges Signal, umfassend eine Mehrzahl von elektrischen Schaltungen (22) zum Erzeugen eines analogen Signals für ein Schienenfahrzeug (10), wobei jede elektrische Schaltung (22) zwei Eingangsanschlüsse (30, 32) umfasst, welche dazu eingerichtet sind, eine vorbestimmte elektrische Spannung zu empfangen, welche zwischen den Eingangsanschlüssen (30, 32) definiert ist, wobei jede elektrische Schaltung (22) ferner einen Hauptzweig (34) umfasst, welcher die Eingangsanschlüsse (30, 32) verbindet,

   wobei der Hauptzweig (34) eine Mehrzahl von Detektionswiderständen (R1, R2) umfasst, welche in Reihe zwischen den Eingangsanschlüssen (30, 32) verbunden sind, wobei jeder Detektionswiderstand (R1, R2) einen verschiedenen Wert bezüglich jedes Werts der anderen Detektionswiderstände (R1, R2) aufweist, und der Hauptzweig ferner für jeden Detektionswiderstand (R1, R2) zwei Kurzschlussanschlüsse (40) umfasst, welche dazu eingerichtet sind, den entsprechenden Detektionswiderstand (R1, R2) kurzzuschließen, wenn ein Zustandskontakt (I1, I2), welcher die Kurzschlussanschlüsse (40) verbindet, in einem geschlossenen Zustand ist, wobei jede elektrische Schaltung (22) ferner wenigstens einen Ausgangsanschluss (36) umfasst, welcher mit dem Hauptzweig (34) derart verbunden ist, dass das analoge Signal erhalten wird, welches eine eindeutige Spannung abhängig vom Zustand jedes Zustandskontakts (I1, I2) umfasst, wobei das Detektionssystem (16) ferner für jeden Detektionswiderstand (R1, R2) den Zustandskontakt (I1, I2) umfasst, welcher dazu eingerichtet ist, die entsprechenden Kurzschlussanschlüsse (40) in dem geschlossenen Zustand zu verbinden, wobei der Zustand von jedem Zustandskontakt (I1, I2) von einem Betriebszustand einer Ausrüstung (12, 14) des Fahrzeugs (10) abhängt, welche dem Zustandskontakt (I1, I2) zugeordnet ist, wobei vorzugsweise jeder Zustandskontakt (I1, I2) in dem geschlossenen Zustand ist, wenn die zugeordnete Ausrüstung (12, 14) des Zustandskontakts (I1, I2) in einem nominalen Betriebszustand ist, wobei das Detektionssystem (16) ferner ein Eingangs-/Ausgangsmodul (24) umfasst, welches dazu eingerichtet ist, das analoge Signal von jeder elektrischen Schaltung (22) zu empfangen, und dazu eingerichtet ist, ein Detektionssignal, welches das analoge Signal von jeder elektrischen Schaltung (22) umfasst, zu einer Steuerung (18) des Fahrzeugs (10) zu übertragen.

2. Detektionssystem (16) nach Anspruch 1, wobei der Hauptzweig (34) ferner einen Dienstwiderstand (R0) umfasst, welcher in Reihe zwischen einem der Detektionswiderstände (R1, R2) und einem der Eingangsanschlüsse (30, 32) verbunden ist, wobei der Ausgangsanschluss (36) an einem Mittelpunkt zwischen dem Detektionswiderstand (R1, R2) und dem Dienstwiderstand (R0) verbunden ist.

3. Detektionssystem (16) nach Anspruch 2, wobei die eindeutige Spannung die Spannung zwischen dem Ausgangsanschluss (36) und einem der Eingangsanschlüsse (30, 32) ist,

4. Detektionssystem (16) nach einem der vorhergehenden Ansprüche, ferner umfassend wenigstens eine Diode (38), welche die Eingangsanschlüsse (30, 32) verbindet, vorzugsweise die Eingangsanschlüsse (30, 32) durch eine Verbindung parallel zu dem Hauptzweig (34) verbindet, wobei die Diode vorzugsweise eine Zener-Diode ist.

5. Detektionssystem (16) nach einem der vorhergehenden Ansprüche, welches in Form einer oberflächenmontierten Komponente ausgeführt ist.

6. Detektionssystem (16) nach einem der vorhergehenden Ansprüche, wobei der eindeutige Spannungswert die folgende Gleichung erfüllt, wenn der Zustandskontakt von einem der Detektionswiderstände (R1, R2), welcher als aktiver Widerstand bezeichnet wird, in einem offenen Zustand ist:

$$V_S = \frac{R_{0,t} \cdot V_E}{R_{0,t} + R_X}$$

   wobei:
   $V_S$ der eindeutige Spannungswert ist, welcher in dem analogen Signal umfasst ist:

   $R_{0,t}$ der Wert des Dienstwiderstands ist, vorzugsweise angepasst durch eine vorbestimmte Widerstandstoleranz;
   $V_E$ der vorbestimmte elektrische Spannungswert zwischen den Eingangsanschlüssen (30, 32) ist, und
   $R_X$ der Wert des aktiven Widerstands ist.

**Claims**

1. System (16) for detecting an analog signal comprising a plurality of electrical circuits (22) for generating an analog signal for a rail vehicle (10), each electrical circuit (22) comprising two input terminals (30, 32) configured to receive a predetermined electrical voltage defined between said input terminals (30, 32), each electrical circuit (22) further comprising a main branch (34) connecting said input terminals (30, 32),

wherein the main branch (34) comprises a plurality of sense resistors (R1, R2), connected in series between said input terminals (30, 32), each sense resistor (R1, R2) having a value different from each value of the other sense resistors (R1, R2), and the main branch further comprising, for each sense resistor (R1, R2), two short-circuit terminals (40) configured to short-circuit the respective sense resistor (R1, R2) when a state of a state contact (I1, I2) connecting said short-circuit terminals (40) is in a closed state,

each electrical circuit (22) further comprising at least one output terminal (36) connected to the main branch (34) so as to obtain the analog signal comprising a single voltage dependent on the state of each state contact (I1, 12), the detection system (16) further comprising, for each sense resistor (R1, R2), the state contact (I1, 12) configured to connect the respective short-circuit terminals (40) in the closed state, the state of each state contact (11, I2) depending on an operating state of a piece of equipment (12, 14) of the vehicle (10) associated with said state contact (I1, 12), preferably, each state contact (I1, I2) being in the closed state when the piece of equipment (12, 14) associated with said state contact (I1, 12) is in a nominal operating state,

the detection system (16) further comprising an input/output module (24) configured to receive the analog signal from each electrical circuit (22), and configured to transmit a detection signal comprising the analog signal from each electrical circuit (22) to a controller (18) of the vehicle (10).

2. Detection system (16) according to claim 1, wherein the main branch (34) further comprises a service resistor (R0) connected in series between one of the sense resistors (R1, R2) and one of the input terminals (30, 32), the output terminal (36) being connected to a midpoint between said sense resistor (R1, R2) and the service resistor (R0).

3. Detection system (16) according to claim 2, wherein the single voltage is the voltage between the output terminal (36) and one of the input terminals (30, 32).

4. Detection system (16) according to any one of the preceding claims, further comprising at least one diode (38) connecting the input terminals (30, 32), preferably connecting the input terminals (30, 32) via a connection parallel to the main branch (34), the diode preferably being a Zener diode.

5. Detection system (16) according to any one of the preceding claims, made in the form of a surface-mounted component.

6. Detection system (16) according to any one of the preceding claims, wherein the value of the single voltage satisfies the following equation, when the state contact of one of the sense resistors (R1, R2), referred to as the active resistor, is in an open state:

$$V_S = \frac{R_{0,t} \cdot V_E}{R_{0,t} + R_X}$$

where:

$V_s$ is the value of the single voltage comprised in the analog signal;
$R_{0,t}$ is the value of the service resistor, preferably adjusted by a predetermined resistor tolerance;
$V_E$ is the value of the predetermined electrical voltage between the input terminals (30, 32), and
$R_X$ is the value of the active resistor.

FIG.1

EP 4 414 714 B1

## RÉFÉRENCES CITÉES DANS LA DESCRIPTION

**Documents brevets cités dans la description**

- US 20180143250 A1
- CN 216772219 U
- US 20120182065 A
- US 4994733 A1